# EUROPEAN PATENT APPLICATION

(11) **EP 4 672 305 A1**
(43) Date of publication of application: **31.12.2025**
(21) Application number: 23924227.4
(22) Date of filing: 15.12.2023
(51) Int. Cl.: H01L 21/336, H01L 29/78, H01L 29/12

(54) **METHOD FOR PRODUCING FIELD EFFECT TRANSISTOR**

(30) Priority: 24.02.2023 JP 2023027494
(71) Applicant: DENSO CORPORATION, Kariya-shi, Aichi 448-8661 (JP)
(72) Inventor: TAKAYA, Hidefumi, Kariya-shi, Aichi 448-8661 (JP)
(74) Representative: Kuhnen & Wacker Patent- und Rechtsanwaltsbüro PartG mbB
(86) International application number: PCT/JP2023/044980
(87) International publication number: WO 2024/176583

(57) **Abstract**

A p-type impurity concentration in a p-type trench underlayer is appropriately adjusted. A method for producing a field effect transistor includes: a body layer formation step of forming a p-type body layer by ion-implanting a p-type impurity; a trench formation step of forming a trench in an upper surface of a semiconductor substrate; a p-type trench underlayer formation step of forming the p-type trench underlayer below the trench by implanting a p-type impurity into a bottom surface of the trench while the upper surface of the semiconductor substrate is covered with an ion implantation mask; and a gate electrode formation step of forming a gate insulating film and a gate electrode in the trench. In the p-type trench underlayer formation step, the p-type impurity is implanted at a higher concentration than in the body layer formation step.

## Description

### TECHNICAL FIELD

### (CROSS REFERENCE TO RELATED APPLICATIONS)

This application is a related application of Japanese Patent Application No. 2023-027494 filed on February 24, 2023, and claims priority based on this Japanese patent application, the disclosure of which is incorporated herein by reference in its entirety.

The technology disclosed in this description relates to a method for producing a field effect transistor.

JP 2009-194065 A discloses a trench gate type field effect transistor. The field effect transistor includes multiple p-type deep layers protruding downward from a body layer. Each of the p-type deep layers extends to intersect the trench when a semiconductor substrate is viewed from the upper side. The p-type deep layers are arranged at an interval in a width direction. An n-type deep layer is provided within each gap. Each of the p-type deep layers and the n-type deep layers extends from the body layer to a position below the bottom surface of the trench. An n-type drift layer is disposed below the p-type deep layer and the n-type deep layer. This structure makes it possible to improve the breakdown voltage of the field effect transistor.

### SUMMARY OF INVENTION

In a field effect transistor having a p-type deep layer and an n-type deep layer, when a p-layer (hereinafter referred to as a p-type trench underlayer) is provided at the bottom of the trench to extend along the trench, the feedback capacitance of the field effect transistor can be reduced, such that highspeed switching can be achieved. This description proposes a technique for effectively reducing the feedback capacitance of a field effect transistor by appropriately adjusting the p-type impurity concentration in the p-type trench underlayer in a producing process of the field effect transistor.

A method for producing a field effect transistor disclosed in this specification includes: a semiconductor substrate preparation step; a body layer formation step; a trench formation step; a p-type trench underlayer formation step; and a gate electrode formation step. In the semiconductor substrate preparation step, a semiconductor substrate having an n-type drift layer, a plurality of p-type deep layers, and a plurality of n-type deep layers is prepared. The p-type deep layers and the n-type deep layers are disposed on the n-type drift layer. When the semiconductor substrate is viewed from the upper side, the p-type deep layers extend along a first direction and are arranged at interval in a second direction perpendicular to the first direction. Each of the n-type deep layers is disposed in the corresponding one of the intervals. The semiconductor substrate is prepared, in which the n-type deep layer has a higher n-type impurity concentration than the n-type drift layer. In the body layer formation step, a p-type body layer is formed in contact with the p-type deep layers and the n-type deep layers from the upper side by ion-implanting a p-type impurity into the semiconductor substrate. In the trench formation step, a trench is formed in the upper surface of the semiconductor substrate, so that the trench intersects with the p-type deep layers, when the semiconductor substrate is viewed from the upper side, and penetrates the body layer, and that the lower end of the trench is located higher than the lower ends of the p-type deep layers. In the p-type trench underlayer formation step, a p-type impurity is implanted into the bottom surface of the trench while the upper surface of the semiconductor substrate is covered with an ion implantation mask, thereby forming a p-type trench underlayer connected to each of the p-type deep layers below the trench. In the gate electrode formation step, a gate insulating film and a gate electrode are formed in the trench. In the p-type trench underlayer formation step, the p-type impurity is implanted at a higher concentration than in the body layer formation step.

The p-type trench underlayer may be formed at a position in contact with the bottom surface of the trench, or may be formed at a position away from the bottom surface of the trench (i.e., at a position deeper than the bottom surface of the trench).

In this producing method, the ion implantation into the body layer and the ion implantation into the p-type trench underlayer are performed in separate steps. Therefore, the p-type impurity concentration in the p-type trench underlayer can be controlled independently of the p-type impurity concentration in the body layer. In the p-type trench underlayer formation step, the p-type impurity is implanted at a higher concentration than in the body layer formation step. Therefore, when a voltage is applied to a field effect transistor manufactured by this producing method, the p-type trench underlayer is unlikely to be depleted. Therefore, the feedback capacitance of the field effect transistor can be effectively reduced.

### BRIEF DESCRIPTION OF DRAWINGS

FIG. 1 is a cross-sectional perspective view of MOSFET 10 (showing an xz cross-section excluding a p-type deep layer 36).
FIG. 2 is a cross-sectional perspective view of MOSFET 10 in which a source electrode 22 and an interlayer insulating film 20 are omitted (showing an xz cross-section excluding a p-type deep layer 36).
FIG. 3 is an enlarged xy cross-sectional view of MOSFET 10 including a p-type trench underlayer 35, a p-type deep layer 36 and an n-type deep layer 37, showing an arrangement of a p-type trench underlayer 35, a p-type deep layer 36 and an n-type deep layer 37 when a semiconductor substrate 12 is viewed from an upper side.
FIG. 4 is an enlarged xy cross-sectional view of MOSFET 10 including a trench 14, a p-type deep layer 36 and an n-type deep layer 37, showing an arrangement of a trench 14, a p-type deep layer 36 and a n-type deep layer 37 when a semiconductor substrate 12 is viewed from an upper side.
FIG. 5 is an enlarged yz cross-sectional view of MOSFET 10 including a p-type deep layer 26 and an n-type deep layer 37.
FIG. 6 is a cross-sectional perspective view of MOSFET 10 (showing an xz cross-section including a p-type deep layer 36).
FIG. 7 is a cross-sectional view showing a distribution of non-depleted regions in a p-type trench underlayer 35.
FIG. 8 is an explanatory diagram of a producing method of MOSFET 10.
FIG. 9 is an explanatory diagram of a producing method of MOSFET 10.
FIG. 10 is an explanatory diagram of a producing method of MOSFET 10.
FIG. 11 is an explanatory diagram of a producing method of MOSFET 10.
FIG. 12 is an explanatory diagram of a producing method of MOSFET 10.
FIG. 13 is an explanatory diagram of a producing method of MOSFET 10.
FIG. 14 is an explanatory diagram of a producing method of MOSFET 10.
FIG. 15 is an explanatory diagram of a producing method of MOSFET 10.
FIG. 16 is an explanatory diagram of a producing method of a modification.
FIG. 17 is a cross-sectional perspective view of MOSFET according to a first modification, corresponding to FIG. 1.
FIG. 18 is a cross-sectional perspective view of MOSFET according to a second modification, corresponding to FIG. 1.
FIG. 19 is a cross-sectional perspective view of MOSFET according to a third modification, corresponding to FIG. 1.
FIG. 20 is a cross-sectional perspective view of MOSFET according to a fourth modification, corresponding to FIG. 1.
FIG. 21 is a cross-sectional perspective view of MOSFET according to a fifth modification, corresponding to FIG. 1.
FIG. 22 is a cross-sectional perspective view of MOSFET according to a sixth modification, corresponding to FIG. 1.
FIG. 23 is a cross-sectional perspective view of MOSFET according to a seventh modification, corresponding to FIG. 1.
FIG. 24 is a cross-sectional perspective view of MOSFET according to an eighth modification, corresponding to FIG. 1.
FIG. 25 is a cross-sectional perspective view of MOSFET according to a ninth modification, corresponding to FIG. 6.

### DESCRIPTION OF EMBODIMENTS

In an exemplary producing method disclosed in the present description, an ion implantation depth in the p-type trench underlayer formation step may be shallower than an ion implantation depth in the body layer formation step.

In the p-type trench underlayer formation step, ion implantation may be performed multiple times while changing the ion implantation depth. In this case, the ion implantation depth in the p-type trench underlayer formation step means the deepest ion implantation depth in the p-type trench underlayer formation step. In the body layer formation step, ion implantation may be performed multiple times while changing the ion implantation depth. In this case, the ion implantation depth in the body layer formation step means the deepest ion implantation depth in the body layer formation step.

According to this configuration, a thin p-type trench underlayer can be formed, and the breakdown voltage of the field effect transistor can be improved.

In one example of the producing method disclosed in the present description, in the p-type trench underlayer formation step, the p-type trench underlayer may be formed such that a lower end of the p-type trench underlayer is positioned higher than a lower end of each of the n-type deep layers.

According to this configuration, when the field effect transistor is in an on state, the depletion layer is less likely to extend from the p-type trench underlayer to the drift layer, so that the on-resistance of the field effect transistor can be reduced.

In one example of the producing method disclosed in this description, in the p-type trench underlayer formation step, the p-type trench underlayer may be formed so that the p-type trench underlayer is in contact with the bottom surface of the trench. The total amount of p-type impurity in the p-type trench underlayer may be set so that a non-depleted region remains in a part of the p-type trench underlayer in contact with the gate insulating film when a rated voltage is applied to the field effect transistor.

According to this configuration, the feedback capacitance of the field effect transistor can be effectively reduced.

In one example of the producing method disclosed in the present description, in the p-type trench underlayer formation step, the p-type trench underlayer is formed to have a first p-type trench underlayer and a second p-type trench underlayer. The second p-type trench underlayer may have a higher p-type impurity concentration than the first p-type trench underlayer and may be located above or below the first p-type trench underlayer.

In one example of the producing method disclosed in this description, in the p-type trench underlayer formation step, the p-type impurity may be implanted into the bottom surface of the trench while the bottom surface and a side surface of the trench are exposed.

According to this configuration, it is possible to form the p-type trench underlayer having a width that is approximately equal to the width of the bottom surface of the trench. According to this configuration, the electric field applied to the gate insulating film can be suppressed, and the on-resistance of the field-effect transistor can be reduced.

In one example of the producing method disclosed in this description, the trench formation step may include forming an etching mask on the upper surface of the semiconductor substrate, and etching the upper surface of the semiconductor substrate through the etching mask to form the trench. In the p-type trench underlayer formation step, the etching mask may be used as the ion implantation mask.

According to this configuration, the field effect transistor can be manufactured efficiently.

In one example of the producing method disclosed in the present description, in the semiconductor substrate preparation step, the semiconductor substrate having an n-type connection layer is prepared. The n-type connection layer may be disposed below each of the p-type deep layers to connect the n-type deep layers together. The n-type connection layer may have a higher n-type impurity concentration than the n-type drift layer.

According to this configuration, when the field effect transistor is in the on state, the depletion layer is less likely to extend from the p-type deep layer to the drift layer, so that the on-resistance of the field effect transistor can be reduced.

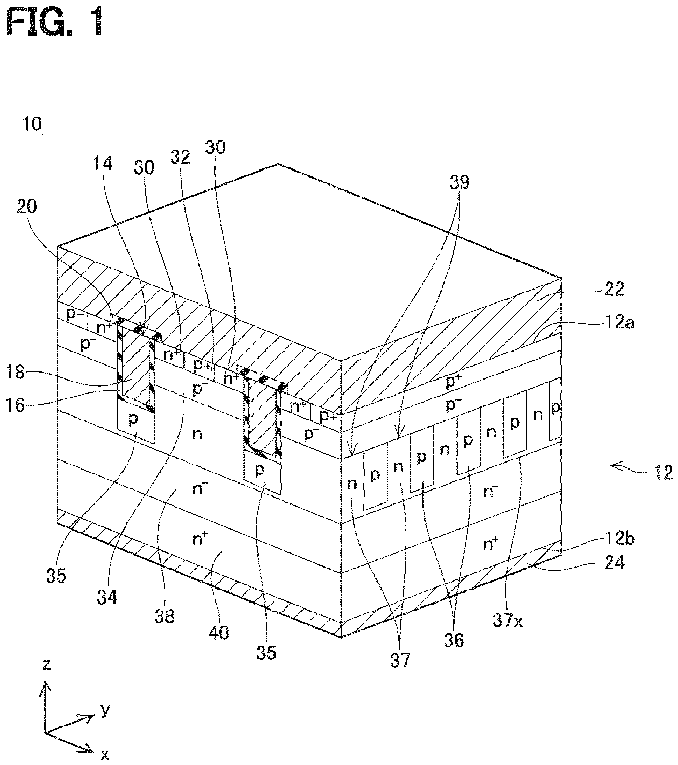

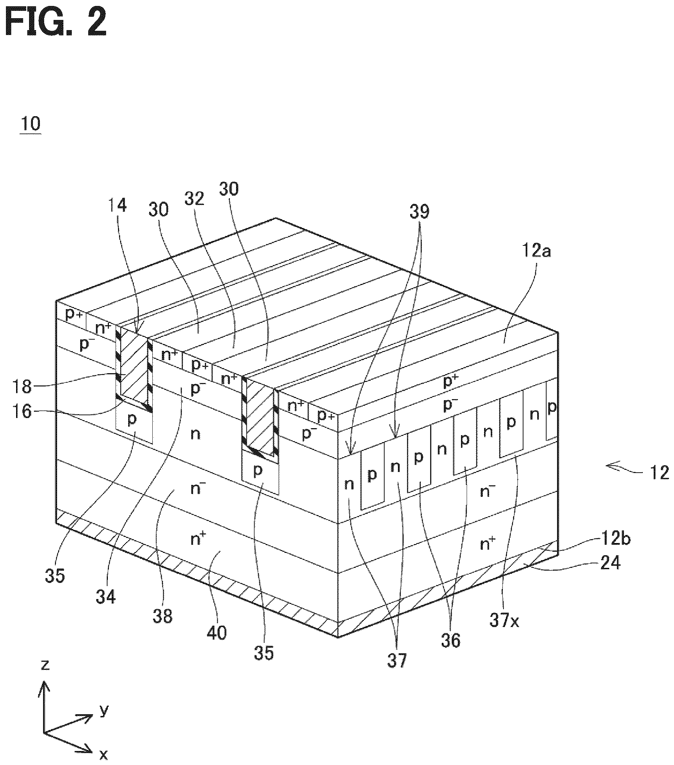

A metal-oxide-semiconductor field effect transistor (MOSFET) 10 of an embodiment, as shown in FIGS. 1 and 2, includes a semiconductor substrate 12. In the following, a thickness direction of the semiconductor substrate 12 may be referred to as z direction. A direction parallel to an upper surface 12a of the semiconductor substrate 12 (perpendicular to the z direction) may be referred to as x direction. A direction perpendicular to the x direction and the z direction may be referred to as y direction. The semiconductor substrate 12 is made of silicon carbide (SiC). The semiconductor substrate 12 may be made of other material such as silicon or gallium nitride. Trenches 14 are provided in the upper surface 12a of the semiconductor substrate 12. As shown in FIG. 2, the trenches 14 extend in the y direction on the upper surface 12a. The trenches 14 are arranged at intervals in the x direction.

As shown in FIGS. 1 and 2, an inner surface (that is, a bottom surface and a side surface) of each of the trenches 14 is covered with a gate insulating film 16. A gate electrode 18 is disposed in each of the trenches 14. The gate electrode 18 is insulated from the semiconductor substrate 12 by the gate insulating film 16. As shown in FIG. 1, an upper surface of the gate electrode 18 is covered with an interlayer insulating film 20. A source electrode 22 is disposed on the semiconductor substrate 12. The source electrode 22 covers each of the interlayer insulating films 20. The source electrode 22 is insulated from the gate electrodes 18 by the interlayer insulating films 20. The source electrode 22 is in contact with the upper surface 12a of the semiconductor substrate 12 at position where the interlayer insulating films 20 are not provided. A drain electrode 24 is disposed at a position below the semiconductor substrate 12. The drain electrode 24 is in contact with the entire region of a lower surface 12b of the semiconductor substrate 12.

As shown in FIGS. 1 and 2, the semiconductor substrate 12 has source layers 30, contact layers 32, a body layer 34, p-type trench underlayers 35, p-type deep layers 36, n-type deep layers 37, an n-type connection layer 37x, a drift layer 38, and a drain layer 40.

Each of the source layers 30 is an n-type layer having a high n-type impurity concentration. Each of the source layers 30 is disposed in a range partially including the upper surface 12a of the semiconductor substrate 12. Each of the source layers 30 is in ohmic contact with the source electrode 22. Each of the source layers 30 is in contact with the gate insulating film 16 at an uppermost portion of the side surface of the trench 14. Each of the source layers 30 faces the gate electrode 18 with the gate insulating film 16 interposed therebetween. Each of the source layers 30 extends in the y direction along the side surface of the trench 14.

Each of the contact layers 32 is a p-type layer having a high p-type impurity concentration. Each of the contact layers 32 is disposed in a range partially including the upper surface 12a of the semiconductor substrate 12. Each of the contact layers 32 is disposed between corresponding two source layers 30. Each of the contact layers 32 is in ohmic contact with the source electrode 22. Each of the contact layers 32 extends in the y direction.

The body layer 34 is a p-type layer having a lower p-type impurity concentration than the contact layers 32. The body layer 34 is disposed below the source layers 30 and the contact layers 32. The body layer 34 is in contact with the source layers 30 and the contact layers 32 from below. The body layer 34 is in contact with the gate insulating films 16 on the side surface of the trench 14 located below the source layer 30. The body layer 34 faces the gate electrode 18 with the gate insulating film 16 interposed therebetween.

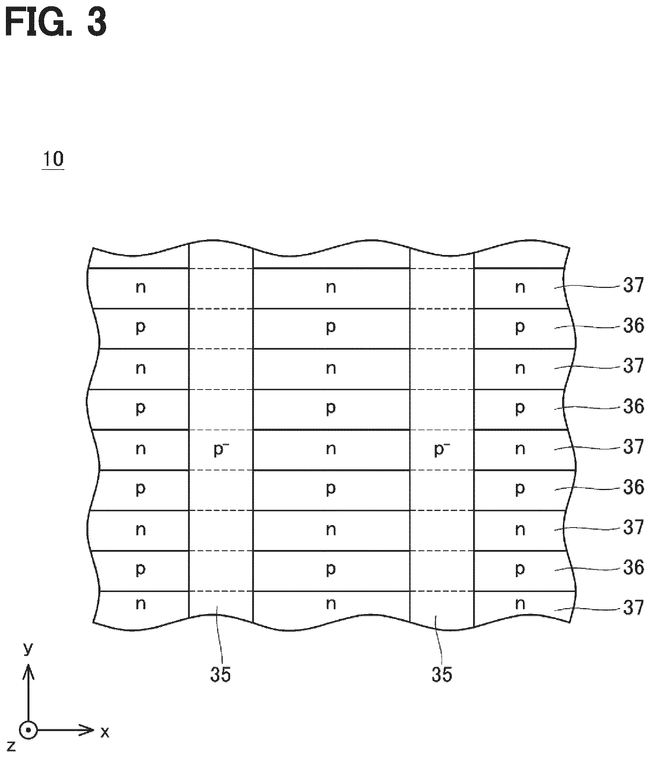

Each of the p-type trench underlayers 35 is a p-type layer located below the corresponding trench 14. The p-type impurity concentration of each p-type trench underlayer 35 is higher than the p-type impurity concentration of the body layer 34 and lower than the p-type impurity concentration of the contact layer 32. Each p-type trench underlayer 35 is in contact with the gate insulating film 16 at the bottom surface of the corresponding trench 14. The width (i.e., the dimension in the x direction) of each p-type trench underlayer 35 is approximately equal to the width (i.e., the dimension in the x direction) of the bottom surface of the trench 14 above the p-type trench underlayer 35. As shown in FIG. 3, when the semiconductor substrate 12 is viewed from above, each p-type trench underlayer 35 extends longitudinally along the longitudinal direction of the corresponding trench 14 (the y direction in this example).

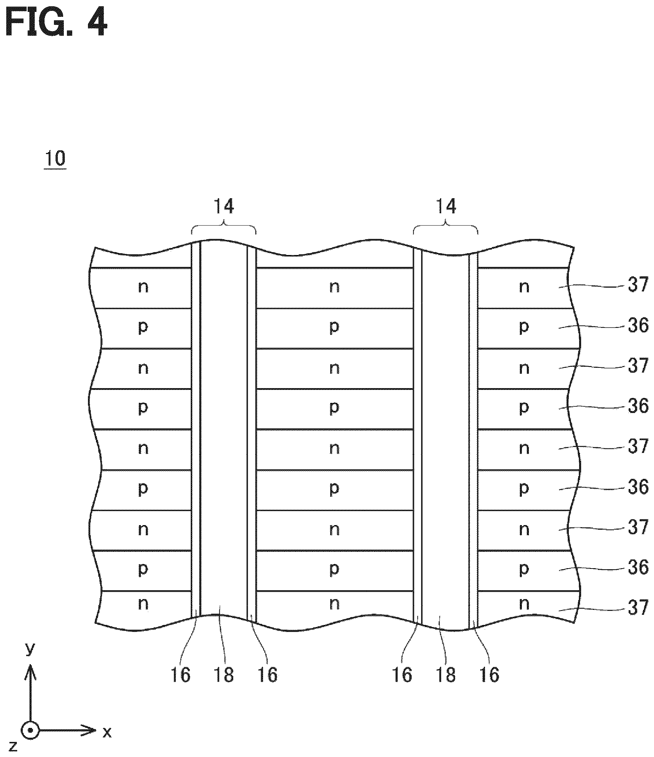

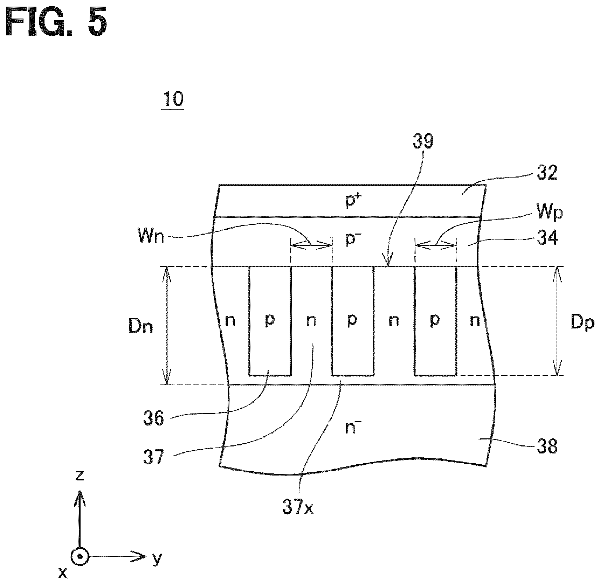

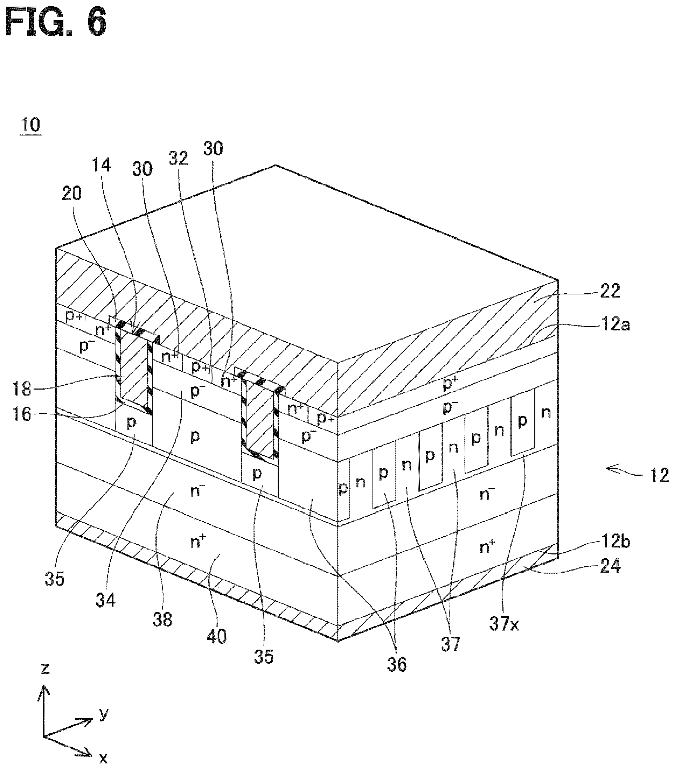

Each of the p-type deep layers 36 is a p-type layer protruding downward from the lower surface of the body layer 34. A p-type impurity concentration of each of the p-type deep layers 36 is higher than the p-type impurity concentration of the body layer 34 and lower than the p-type impurity concentration of the contact layer 32. As shown in FIG. 4, when the semiconductor substrate 12 is viewed from above, each of the p-type deep layers 36 extends in the x direction and is orthogonal to the longitudinal direction (the y direction in this example) of the trench 14. The p-type deep layers 36 are arranged at interval in the y direction. Hereinafter, a space between the p-type deep layers 36 is referred to as a gap 39 (see FIGS. 1 and 2). As shown in FIG. 5, the p-type deep layer 36 has a shape elongated in the z direction in the yz cross section. That is, a dimension of the p-type deep layer 36 in the z direction (hereinafter, referred to as a depth Dp) is larger than a dimension of the p-type deep layer 36 in the y direction (hereinafter, referred to as a width Wp). As shown in FIG. 6, each of the p-type deep layers 36 extends from the lower surface of the body layer 34 to a depth below the bottom surface of each of the trenches 14. Each of the p-type deep layers 36 is in contact with the gate insulating film 16 on the side surface of each of the trenches 14 located below the body layer 34. As shown in FIG. 3, each of the p-type deep layers 36 is in contact with the p-type trench underlayer 35 disposed below the trench 14.

Each n-type deep layer 37 is an n-type layer disposed in the corresponding gap 39. Each n-type deep layer 37 has a higher n-type impurity concentration than the drift layer 38. As shown in FIGS. 1 and 2, each n-type deep layer 37 is in contact with the lower surface of the body layer 34. Each of the n-type deep layers 37 is in contact with the side surfaces of the p-type deep layer 36 on both sides thereof. Each of the n-type deep layers 37 extends from the lower surface of the body layer 34 to a depth below the bottom surface of each of the trenches 14 and the lower surface of each of the p-type deep layers 36. As shown in FIG. 5, each of the n-type deep layers 37 in the gap 39 has a shape elongated in the z direction in the yz cross section. That is, a dimension of each of the n-type deep layers 37 in the z direction (hereinafter, referred to as a depth Dn) is larger than a dimension of each of the n-type deep layers 37 in the gap 39 in the y direction (hereinafter, referred to as a width Wn). As illustrated in FIGS. 1 and 2, each of the n-type deep layers 37 is in contact with the gate insulating film 16 on the side surface of each of the trenches 14 located below the body layer 34 in each gap 39. As shown in FIG. 3, each of the n-type deep layers 37 is in contact with the p-type trench underlayer 35 disposed below the trench 14.

As shown in FIG. 5, the n-type connection layer 37x is disposed below each p-type deep layer 36. The n-type connection layer 37x has a higher n-type impurity concentration than the drift layer 38. The n-type connection layer 37x has approximately the same n-type impurity concentration as the n-type deep layer 37. Each n-type connection layer 37x is in contact with the lower surface of the corresponding p-type deep layer 36. Each n-type connection layer 37x connects two n-type deep layers 37 located on either side of the p-type deep layer 36 to each other.

The drift layer 38 is an n-type layer having an n-type impurity concentration lower than each of the n-type deep layers 37. The drift layer 38 is disposed below the n-type deep layer 37 and the n-type connection layer 37x. The drift layer 38 is in contact with the n-type deep layer 37 and the n-type connection layer 37x from the lower side.

The drain layer 40 is an n-type layer having a higher n-type impurity concentration than the drift layer 38 and the n-type deep layers 37. The drain layer 40 is in contact with the drift layer 38 from below. The drain layer 40 is arranged in a region including the lower surface 12b of the semiconductor substrate 12. The drain layer 40 is in ohmic contact with the drain electrode 24.

The following describes an operation of the MOSFET 10. When the MOSFET 10 is used, a higher potential is applied to the drain electrode 24 as compared to the source electrode 22. When a potential equal to or higher than a gate threshold value is applied to the gate electrode 18, a channel is formed in the body layer 34 in the vicinity of the gate insulating film 16. The source layer 30 and the n-type deep layer 37 are connected by the channel. Therefore, electrons flow from the source layer 30 to the drain layer 40 through the channel, the n-type deep layer 37, and the drift layer 38. That is, the MOSFET 10 is turned on. When the potential of the gate electrode 18 is reduced from a value equal to or higher than the gate threshold value to a value less than the gate threshold value, the channel disappears and the flow of electrons stops. In other words, the MOSFET 10 is turned off.

Next, the operation, when the MOSFET 10 is turned on, will be described in more detail. When the channel is formed, electrons flow from the source layer 30 through the channel into the n-type deep layer 37. The electrons flow from the top to the bottom of the n-type deep layer 37 and flow into the drift layer 38. Therefore, a path through which electrons flow (i.e., a current path) is formed in the n-type deep layer 37. When the MOSFET 10 is in an on-state, a depletion layer of a certain width extends from the p-type trench underlayer 35 and the p-type deep layer 36 to the n-type deep layer 37 due to a built-in potential. The wider the depletion layer in the n-type deep layer 37, the narrower the current path in the n-type deep layer 37. In this embodiment, the n-type deep layer 37 has a higher n-type impurity concentration than the drift layer 38, so that the width of the depletion layer extending into the n-type deep layer 37 is narrow. Therefore, a wide current path is ensured within the n-type deep layer 37. This reduces the on-resistance of the MOSFET.

In addition, since the n-type impurity concentration in the drift layer 38 is low, a depletion layer easily spreads in the drift layer 38. If the p-type trench underlayer 35 and the p-type deep layer 36 were in direct contact with the drift layer 38, a relatively wide depletion layer would extend from the p-type trench underlayer 35 and the p-type deep layer 36 to the drift layer 38 when the MOSFET 10 is in the on state. In this case, the depletion layer narrows the current path in the drift layer 38, increasing the on-resistance of the MOSFET 10. In contrast, in this embodiment, the n-type deep layer 37 and the n-type connection layer 37x having a higher n-type impurity concentration than the drift layer 38 are provided below the p-type trench underlayer 35 and the p-type deep layer 36. That is, the p-type trench underlayer 35 and the p-type deep layer 36 are not in contact with the drift layer 38. Therefore, when the MOSFET 10 is in the on state, a depletion layer is unlikely to spread in the drift layer 38. Therefore, in the MOSFET 10 of this embodiment, the on-resistance is further reduced.

Next, the operation, when the MOSFET 10 is turned off, will be described in more detail. When the channel disappears, a reverse voltage is applied to a pn junction at an interface between the body layer 34 and each of the n-type deep layers 37. Therefore, a depletion layer spreads from the body layer 34 to each of the n-type deep layers 37. Each of the p-type deep layers 36 is electrically connected to the body layer 34 and has substantially the same potential as the body layer 34. Therefore, when the channel disappears, a reverse voltage is also applied to a pn junction at an interface between each of the p-type deep layers 36 and each of the n-type deep layers 37. Therefore, a depletion layer spreads from the p-type deep layer 36 to the n-type deep layer 37. Furthermore, each of the p-type trench underlayers 35 is electrically connected to the body layer 34 via each of the p-type deep layers 36, and has substantially the same potential as the body layer 34. Therefore, when the channel disappears, a reverse voltage is also applied to a pn junction at an interface between each of the p-type trench underlayers 35 and each of the n-type deep layers 37. Therefore, the depletion layer spreads from the p-type trench underlayer 35 to the n-type deep layer 37. Thus, each of the n-type deep layers 37 is quickly depleted by a depletion layer spreading from the body layer 34, the p-type trench underlayer 35 and the p-type deep layer 36. Since each of the p-type trench underlayers 35 is provided under the corresponding trench 14, the periphery of the bottom surface of the trench 14 is well depleted. Accordingly, the electric field concentration in the vicinity of the bottom surface of the trench 14 can be greatly lessened. Since the width of the p-type trench underlayer 35 is approximately equal to the width of the bottom surface of the trench 14, the electric field applied to the gate insulating film 16 covering the bottom surface of the trench 14 can be suitably relaxed. In addition, the entire portion of each of the n-type deep layers 37 is depleted by the depletion layers extending from the body layer 34, the p-type trench underlayer 35, and the p-type deep layer 36. Since each of the n-type deep layers 37 has the n-type impurity concentration higher than that of the drift layer 38, a depletion layer is less likely to spread in each of the n-type deep layers 37 than in the drift layer 38. However, since each n-type deep layer 37 is interposed between the p-type deep layers 36, each n-type deep layer 37 is entirely depleted. Moreover, the depletion layer spreads to the drift layer 38 via each n-type deep layer 37 and the n-type connection layer 37x. Since the n-type impurity concentration of the drift layer 38 is low, almost the entire portion of the drift layer 38 is depleted. The high voltage applied between the drain electrode 24 and the source electrode 22 is held by the depleted drift layer 38 and each of the n-type deep layers 37. Therefore, the MOSFET 10 has a high breakdown voltage.

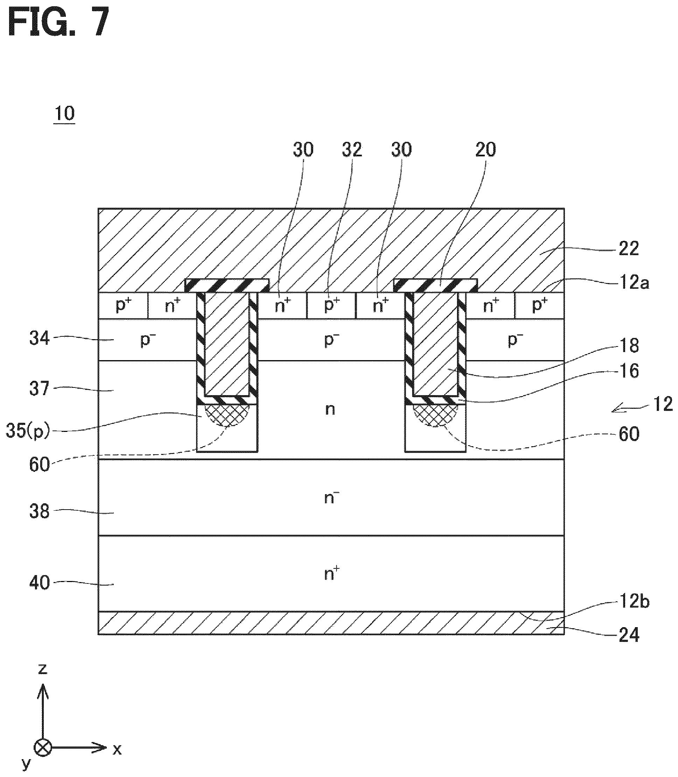

Furthermore, when the MOSFET 10 is turned off, a depletion layer extends from the n-type deep layer 37 to the p-type trench underlayer 35. As described above, the p-type impurity concentration of the p-type trench underlayer 35 is higher than the p-type impurity concentration of the body layer 34. Therefore, the depletion layer does not easily spread into the p-type trench underlayer 35, and a non-depleted region remains in the p-type trench underlayer 35 when the MOSFET 10 is in the off state. In this embodiment, the total amount of p-type impurity in each p-type trench underlayer 35 is set so that a non-depleted region remains in each p-type trench underlayer 35 when a rated voltage is applied between the drain electrode 24 and the source electrode 22. Therefore, as shown in FIG. 7, a non-depleted region 60 remains in a part of the p-type trench underlayer 35 in contact with the gate insulating film 16 covering the bottom surface of the trench 14. In this manner, since the non-depleted region 60 remains under the trench 14 when the MOSFET 10 is in the off state, the electrostatic capacitance (i.e., feedback capacitance) between the gate electrode 18 and the drain electrode 24 is small. This allows the MOSFET 10 to switch at high speed.

Next, the operation, when the body diode of the MOSFET 10 is turned on, will be described. A pn diode (so-called body diode) is formed inside the MOSFET 10 by a p-type anode layer consisting of the contact layer 32, the body layer 34, the p-type deep layer 36, and the p-type trench underlayer 35, and an n-type cathode layer consisting of the n-type deep layer 37, the n-type connection layer 37x, the drift layer 38, and the drain layer 40. When the potential of the source electrode 22 becomes higher than the potential of the drain electrode 24, the body diode turns on. When the body diode is turned on, holes flow from the p-type anode layer into the drift layer 38, and then flow downward within the drift layer 38. When holes reach the interface between the drift layer 38 and the drain layer 40, crystal defects grow at the interface. In this embodiment, the n-type deep layer 37 and the n-type connection layer 37x having a higher n-type impurity concentration than the drift layer 38 are provided below the p-type trench underlayer 35 and the p-type deep layer 36. That is, the p-type trench underlayer 35 and the p-type deep layer 36 are not in contact with the drift layer 38. The n-type deep layer 37 and the n-type connection layer 37x suppress the inflow of holes from the p-type trench underlayer 35 and the p-type deep layer 36 to the drift layer 38. This suppresses the growth of crystal defects at the interface between the drift layer 38 and the drain layer 40.

Next, a producing method of the MOSFET 10 will be described. The MOSFET 10 is manufactured from a semiconductor substrate entirely made of the drain layer 40.

### (Semiconductor substrate preparation step)

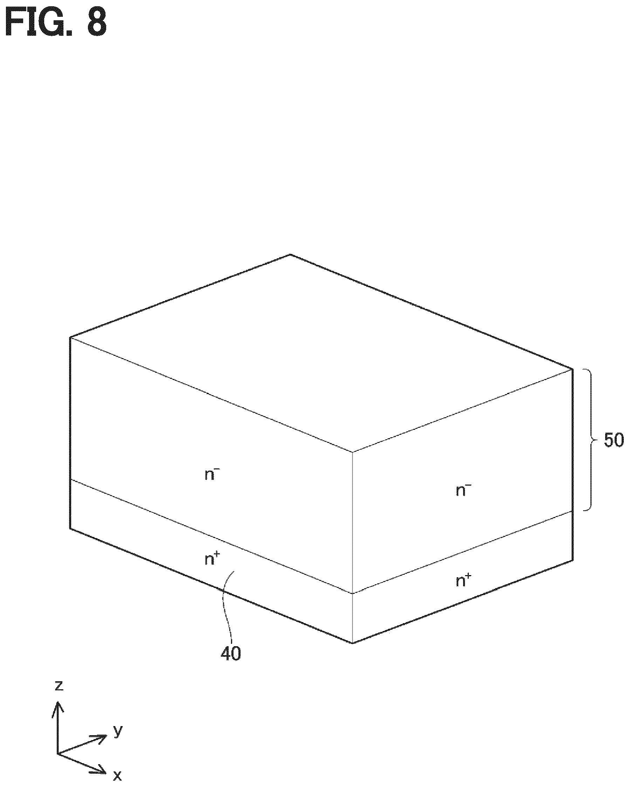

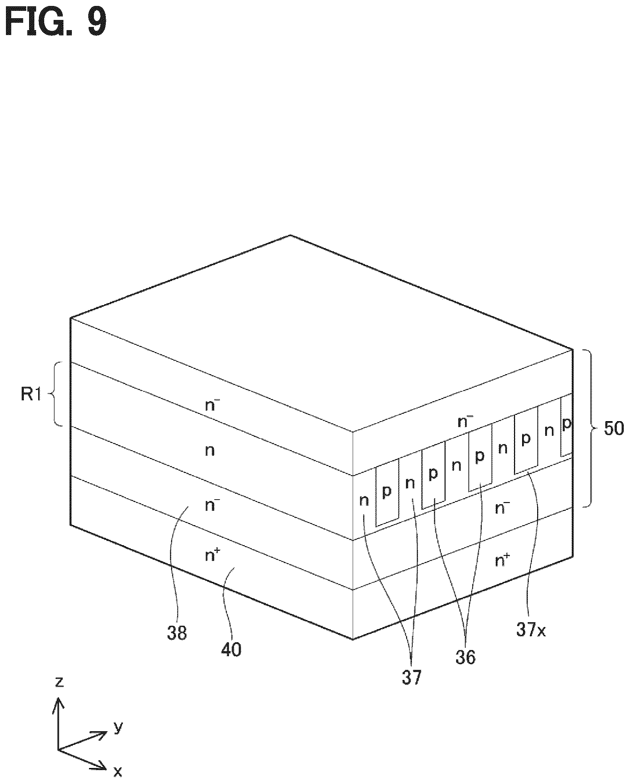

First, a semiconductor substrate preparation step is performed. In the semiconductor substrate preparation step, as shown in FIG. 8, an n-type epitaxial layer 50 is formed on the drain layer 40 by using an epitaxial growth technique. Next, as shown in FIG. 9, ions are implanted into the upper surface of the semiconductor substrate to form the n-type deep layer 37, the n-type connection layer 37x, and the p-type deep layer 36 inside the epitaxial layer 50. The n-type deep layer 37, the n-type connection layer 37x, and the p-type deep layer 36 are formed by introducing n-type impurities and p-type impurities into a depth range R1 away from the upper surface of the semiconductor substrate 12. Specifically, an n-type impurity is introduced planarly into the depth range R1. Next, the p-type deep layer 36 is formed by counter-doping a p-type impurity through a mask toward a part of the depth range R1. The layers remaining as n-type within the depth range R1 become the n-type deep layer 37 and the n-type connection layer 37x. The low-concentration n-type layer remaining below the depth range R1 becomes the drift layer 38. Furthermore, a low-concentration n-type layer remains above the depth range R1.

As described, in this step, a structure is formed in which the p-type deep layers 36 and the n-type deep layers 37 are arranged on the drift layer 38. When viewed from above, the p-type deep layers 36 extend along the x direction and are spaced apart from each other by a gap in the y direction. The deep n-type layer 37 is disposed in each of the gaps. The n-type connection layer 37x is disposed below the p-type deep layer 36 and connects the n-type deep layers 37 to each other. The n-type impurity concentrations of the n-type deep layer 37 and the n-type connection layer 37x are higher than the n-type impurity concentration of the drift layer 38. Alternatively, instead of this example, the n-type deep layer 37, the n-type connection layer 37x and the p-type deep layer 36 may be formed by sequentially introducing n-type impurities and p-type impurities through masks corresponding to the n-type deep layer 37, the n-type connection layer 37x and the p-type deep layer 36, respectively. Furthermore, by previously adjusting the concentration of the n-type impurity within the depth range R1 when epitaxially growing the epitaxial layer 50, it is possible to omit the ion implantation for forming the n-type deep layer 37 and the n-type connection layer 37x.

### (Body layer formation step)

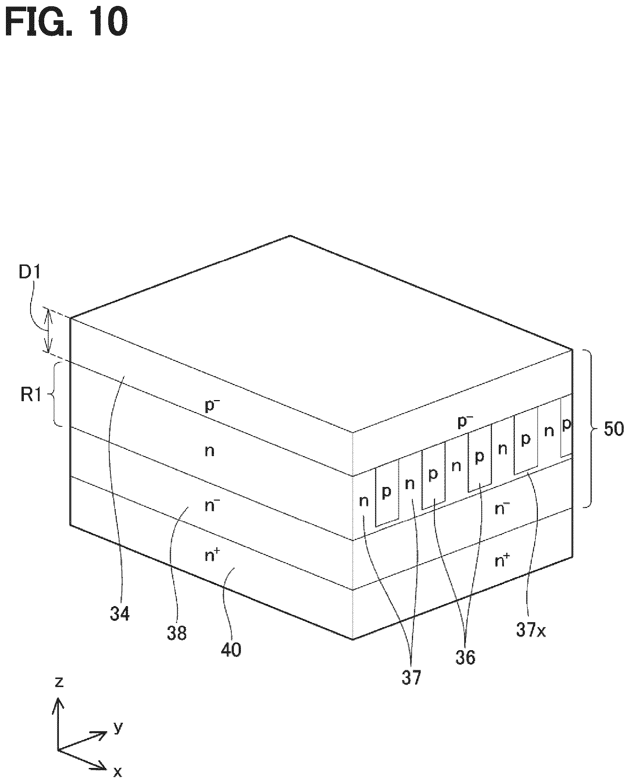

Next, a body layer formation step is carried out. In the body layer formation step, as shown in FIG. 10, the body layer 34 is formed in a surface layer of the semiconductor substrate 12 by ion-implanting p-type impurities into the upper surface of the semiconductor substrate. The body layer 34 is formed to be in contact with the p-type deep layers 36 and the n-type deep layers 37 from above. The body layer 34 is formed over the entire depth range above the p-type deep layer 36 and the n-type deep layer 37 by implanting p-type impurities multiple times while changing the ion implantation depth. A depth D1 in FIG. 10 is a distance in the z direction from the upper surface of the semiconductor substrate to the lower end of the body layer 34. The depth D1 is the deepest ion implantation depth in the body layer formation step.

### (Diffusion layer formation step)

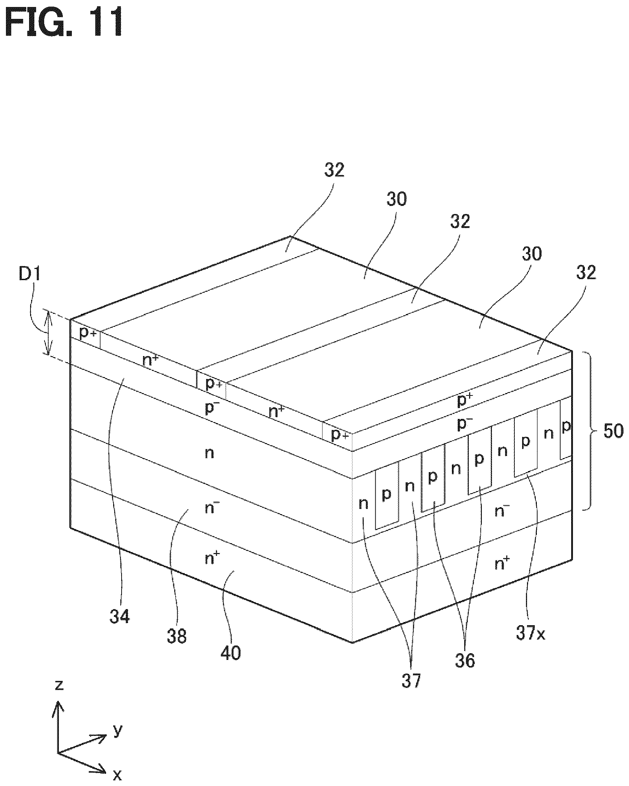

Next, a diffusion layer formation step is carried out. In the diffusion layer formation step, as shown in FIG. 11, an ion implantation technique is used to introduce n-type impurities and p-type impurities into the surface layer of the semiconductor substrate to form the source layer 30 and the contact layer 32.

### (Trench formation step)

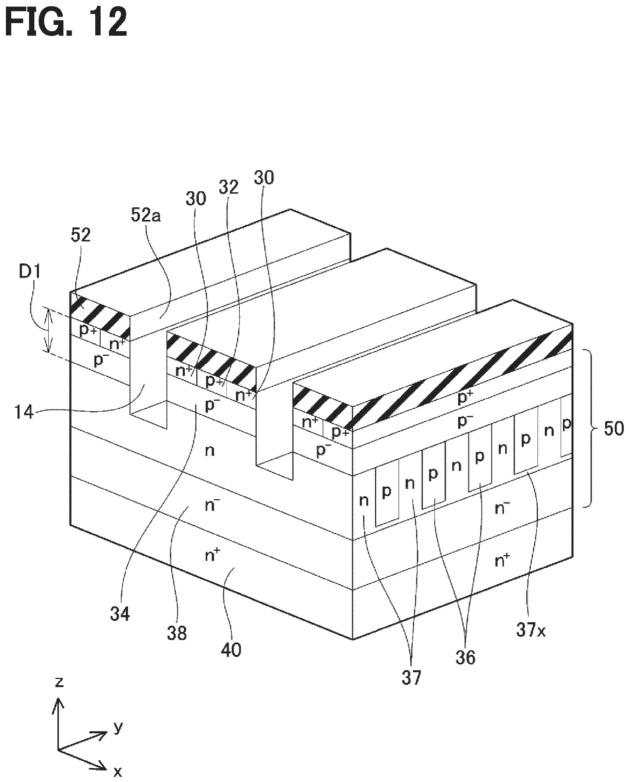

Next, a trench formation step is performed. In the trench formation step, as shown in FIG. 12, an etching mask 52 is formed on the upper surface of the semiconductor substrate (i.e., the upper surface of the epitaxial layer 50). The etching mask 52 has an opening 52a. Next, the upper surface of the semiconductor substrate is dry-etched through the etching mask 52. That is, the upper surface of the semiconductor substrate exposed by the opening 52a is dry-etched, such that the trenches 14 are formed in the upper surface of the semiconductor substrate. Each of the trenches 14 is formed so that, when the epitaxial layer 50 is viewed from above, the trench 14 intersects with the p-type deep layers 36 and the n-type deep layers 37. Each of the trenches 14 is formed to penetrate the source layer 30 and the body layer 34, and the lower end (i.e., the bottom surface) of each trench 14 is located within the depth range of the p-type deep layer 36 and the n-type deep layer 37. That is, the depth of the trench 14 is adjusted so that the bottom end of the trench 14 is located above the bottom ends of the n-type deep layer 37 and the p-type deep layer 36.

### (P-type trench underlayer formation step)

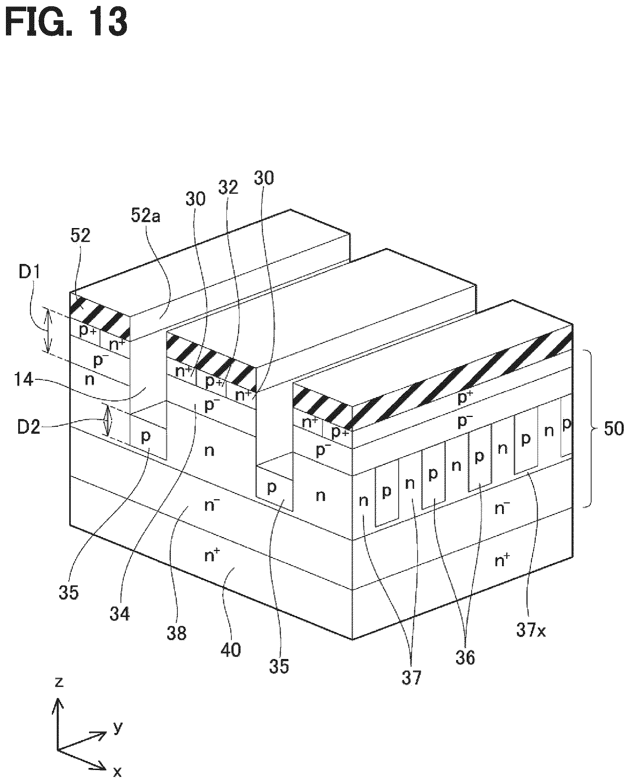

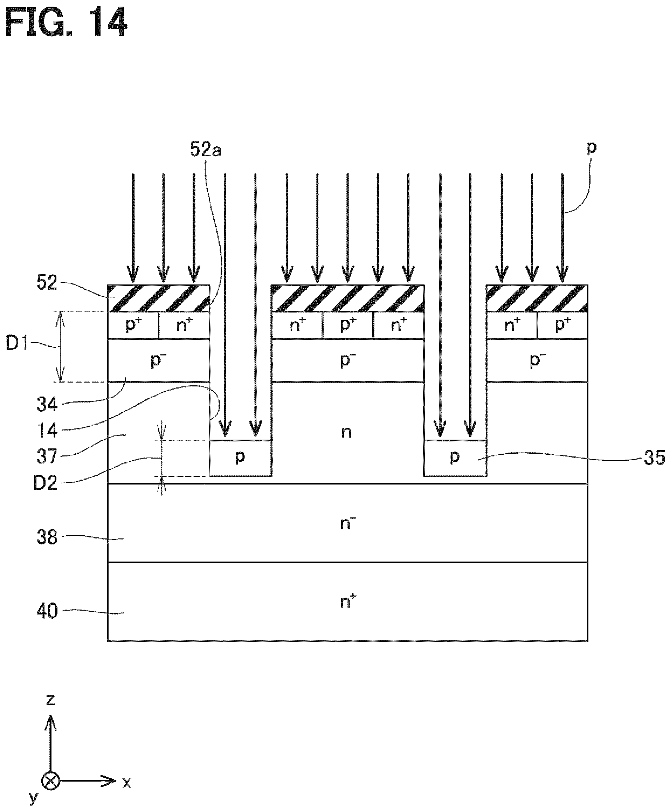

Next, a p-type trench underlayer formation step is carried out. In the p-type trench underlayer formation step, as shown in FIGS. 13 and 14, the p-type trench underlayer 35 is formed by utilizing an ion implantation technique. Specifically, the etching mask 52 used in the trench formation step is used as an ion implantation mask to implant p-type impurities into the semiconductor substrate from above. The ion implantation is performed in a state where the bottom and side surfaces of the trench 14 are exposed. A p-type impurity is implanted into the bottom of the trench 14. Since the side surface of the trench 14 is approximately parallel to the ion implantation direction, almost no p-type impurity is implanted into the side surface of the trench 14. Since the upper surface of the semiconductor substrate is covered with the mask 52, the p-type impurity is not implanted into the upper surface of the semiconductor substrate. Therefore, the p-type impurity can be selectively implanted into the bottom surface of the trench 14. As a result, the p-type trench underlayer 35 is formed below the trench 14. The p-type impurity is implanted multiple times while changing the ion implantation depth, thereby forming the p-type trench underlayer 35 having a predetermined thickness. The p-type trench underlayer 35 is formed in a depth range overlapping with the p-type deep layer 36. Thus, the p-type trench underlayer 35 is connected to each p-type deep layer 36. The p-type trench underlayer 35 is formed so that the p-type trench underlayer 35 is exposed at the bottom surface of the trench 14. Since the bottom and side surfaces of the trench 14 are exposed, the p-type impurity is implanted into the entire bottom surface of the trench 14. Therefore, the p-type trench underlayer 35 having approximately the same width as the bottom surface of the trench 14 is formed. The etching mask 52 is removed after the p-type trench underlayer formation step is performed.

In this embodiment, the ion implantation into the p-type trench underlayer 35 is performed in a separate process from the ion implantation into the body layer 34, so that the p-type impurity concentration of the p-type trench underlayer 35 can be controlled independently of the p-type impurity concentration of the body layer 34. In the p-type trench underlayer formation step, the p-type impurity is implanted at a higher concentration than in the body layer formation step. Therefore, the p-type impurity concentration of the p-type trench underlayer 35 becomes higher than the p-type impurity concentration of the body layer 34. If the p-type impurity concentration of the p-type trench underlayer 35 is increased, the p-type trench underlayer 35 becomes less likely to be depleted when the MOSFET 10 is turned off. Therefore, the feedback capacitance of the MOSFET 10 can be reduced. The total amount of p-type impurities implanted into each p-type trench underlayer 35 is adjusted so that a non-depleted region 60 remains in a part of the p-type trench underlayer 35 in contact with the gate insulating film 16 when a rated voltage is applied to the MOSFET 10 as shown in FIG. 7. Therefore, the feedback capacitance of the MOSFET 10 can be effectively reduced.

The depth D2 in FIGS. 13 and 14 is a distance in the z direction from the bottom surface of the trench 14 to the lower end of the p-type trench underlayer 35. The depth D2 is the deepest ion implantation depth in the p-type trench underlayer formation step. In this embodiment, the ion implantation into the p-type trench underlayer 35 is performed in a separate process from the ion implantation into the body layer 34, so that the ion implantation depth D2 into the p-type trench underlayer 35 can be controlled independently from the ion implantation depth D1 into the body layer 34. In this embodiment, the ion implantation depth D2 is set shallower than the ion implantation depth D1. This makes it possible to form the p-type trench underlayer 35 so that the lower end of the p-type trench underlayer 35 is located higher than the lower end of the n-type deep layer 37. That is, the p-type trench underlayer 35 can be formed so that the lower end of the p-type trench underlayer 35 does not come into contact with the drift layer 38. Therefore, as described above, in the on-state, the depletion layer is less likely to spread into the drift layer 38, and the on-resistance of the MOSFET 10 is reduced.

### (Gate electrode formation step)

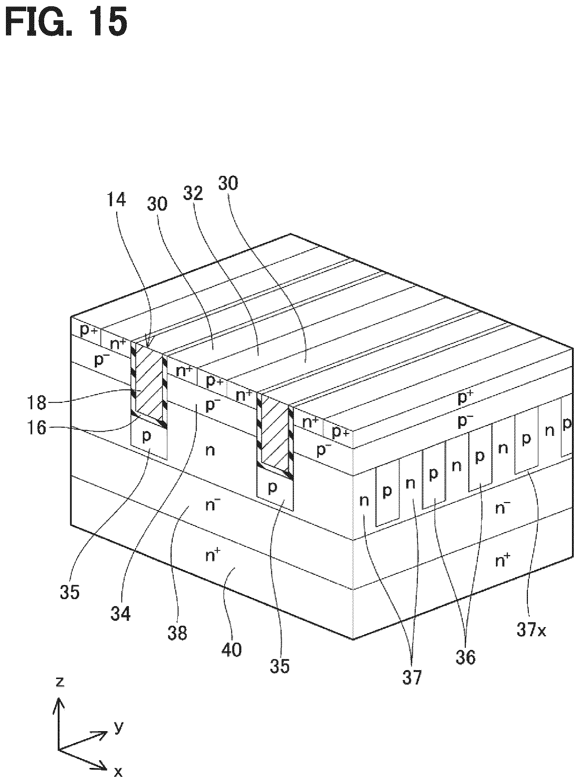

Next, a gate electrode formation step is carried out. In the gate electrode formation step, as shown in FIG. 15, the gate insulating film 16 that covers the inner surface of the trench 14 is formed. Furthermore, the gate electrode 18 is formed in the trench 14.

Next, the interlayer insulating film 20, the source electrode 22, and the drain electrode 24 are formed. Through the above steps, the MOSFET 10 shown in FIG. 1 is completed.

In the producing method, the etching mask 52 is used as an ion implantation mask as it is, so that the MOSFET 10 can be manufactured efficiently. In another embodiment, after removing the etching mask 52, an ion implantation mask may be formed on the upper surface of the semiconductor substrate.

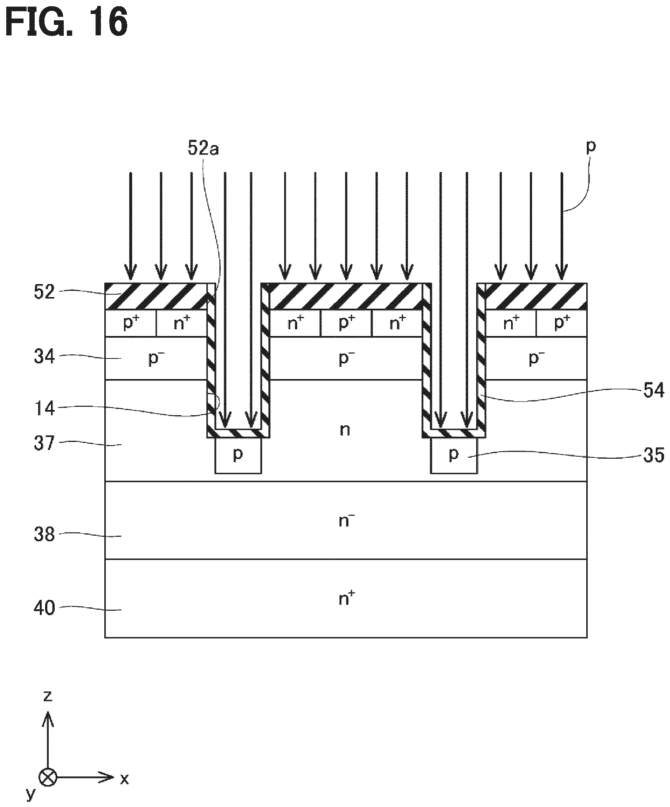

In the producing method, the ion implantation into the p-type trench underlayer 35 is performed in a state where the bottom and side surfaces of the trench 14 are exposed (i.e., in a state where the semiconductor substrate is exposed at the bottom and side surfaces of the trench 14). According to this configuration, since the p-type impurity can be implanted into the entire bottom surface of the trench 14, the p-type trench underlayer 35 having approximately the same width as the bottom surface of the trench 14 can be formed. According to this configuration, the electric field applied to the gate insulating film 16 covering the bottom surface of the trench 14 can be efficiently alleviated. Furthermore, with this configuration, the width of the p-type trench underlayer 35 is not increased more than necessary, so that a wide current path can be secured within the n-type deep layer 37, and the on-resistance of the MOSFET can be reduced. As shown in FIG. 16, the ion implantation into the p-type trench underlayer 35 may be performed after forming a sacrificial oxide film 54 that covers the bottom and side surfaces of the trench 14. This configuration can suppress impurity soak onto the side surface of the trench 14. In this case, the range of implantation of the p-type impurity at the bottom of the trench 14 becomes narrow. However, since the thickness of the sacrificial oxide film 54 is thin, even with this configuration, it is possible to form the p-type trench underlayer 35 having a width close to the width of the bottom surface of the trench 14.

A modified MOSFET will now be described.

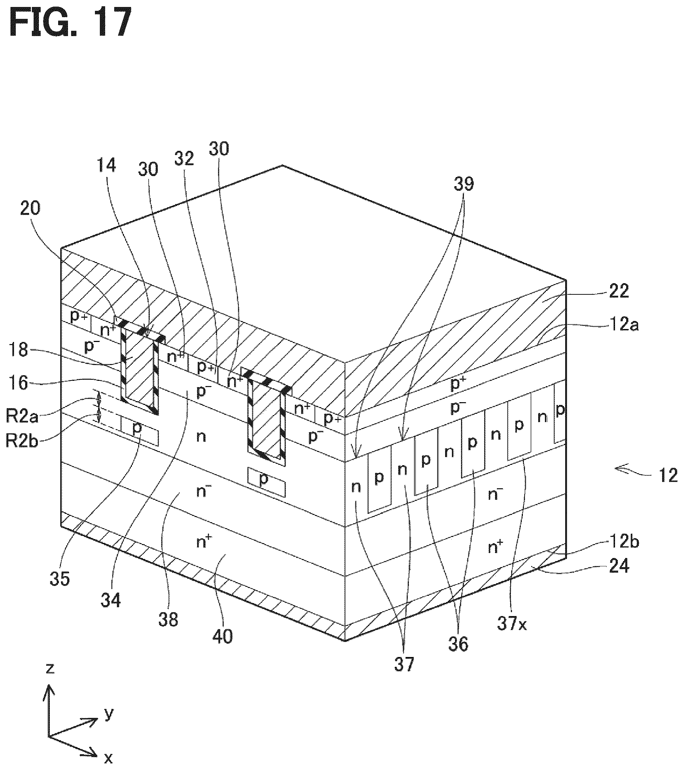

In a MOSFET of a first modification shown in FIG. 17, a p-type trench underlayer 35 is formed at a position spaced downward from the bottom surface of the trench 14. That is, in FIG. 17, the p-type trench underlayer 35 is not formed in a depth range R2a near the bottom surface of the trench 14, but is formed in a depth range R2b apart from the bottom surface of the trench 14. In this way, when the p-type trench underlayer 35 is disposed at a position away from the trench 14, the effects of reducing feedback capacitance and mitigating the electric field can be obtained. In the p-type trench underlayer formation step, the structure of FIG. 17 can be formed by implanting p-type impurities into the depth range R2b without implanting p-type impurities into the depth range R2a.

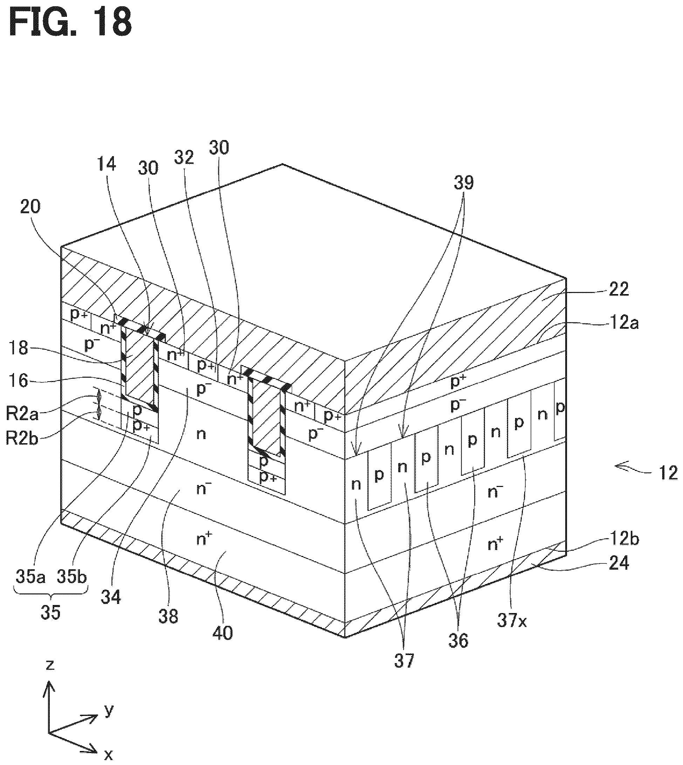

In a MOSFET of a second modification shown in FIG. 18, the p-type trench underlayer 35 has a first p-type trench underlayer 35a and a second p-type trench underlayer 35b. The first p-type trench underlayer 35a is disposed within a depth range R2a near the bottom surface of the trench 14. The second p-type trench underlayer 35b is disposed in a depth range R2b below the depth range R2a. The second p-type trench underlayer 35b has a higher p-type impurity concentration than the first p-type trench underlayer 35a.

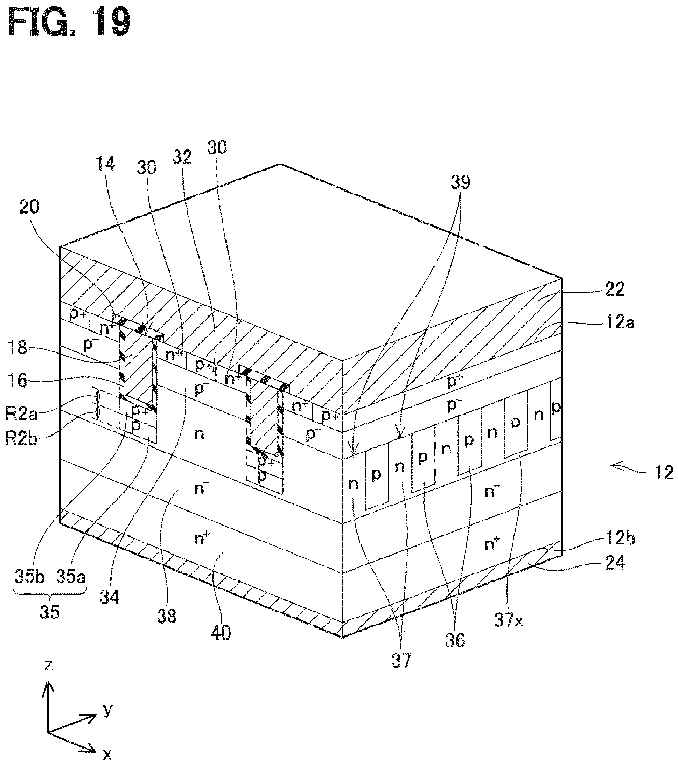

In a MOSFET of a third modification shown in FIG. 19, the second p-type trench underlayer 35b (i.e., a layer with a high p-type impurity concentration) is arranged within the depth range R2a, and the first p-type trench underlayer 35a (i.e., a layer with a low p-type impurity concentration) is arranged within the depth range R2b.

In both the MOSFETs shown in FIGS. 18 and 19, the p-type trench underlayer 35 provides the effects of reducing feedback capacitance and mitigating the electric field. When the second p-type trench underlayer 35b having a high p-type impurity concentration is disposed in contact with the bottom surface of the trench 14 as shown in FIG. 19, the feedback capacitance is lower than that in the case of FIG. 18. The appropriate feedback capacitance varies depending on the application of the MOSFET 10. When a lower feedback capacitance is required, the structure of FIG. 19 can be adopted. When a low feedback capacitance is not required, the structure of FIG. 18 can be adopted. The structure of FIG. 18 can be formed by implanting a low concentration of p-type impurities into the depth range R2a and a high concentration of p-type impurities into the depth range R2b in the p-type trench underlayer formation step. The structure of FIG. 19 can be formed by implanting a high concentration of p-type impurities into the depth range R2a and a low concentration of p-type impurities into the depth range R2b in the p-type trench underlayer formation step.

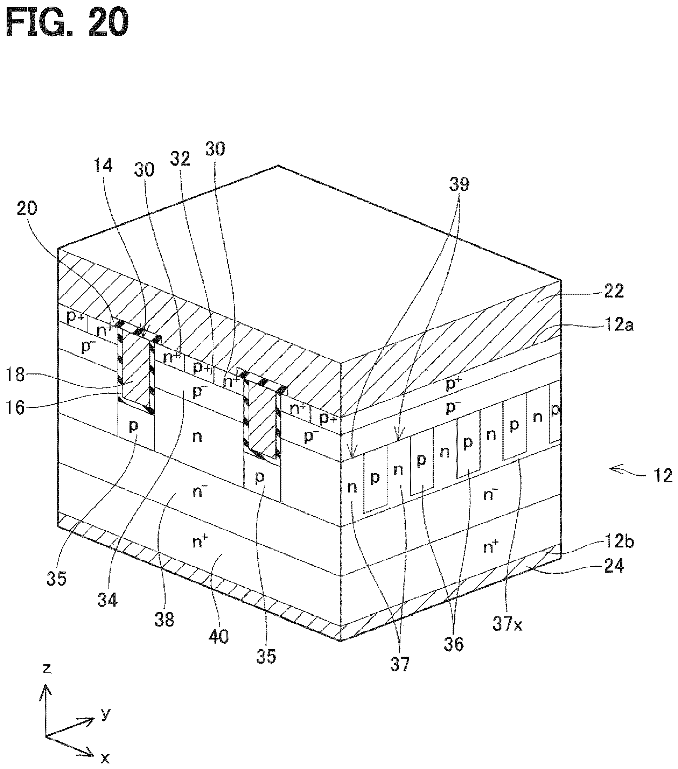

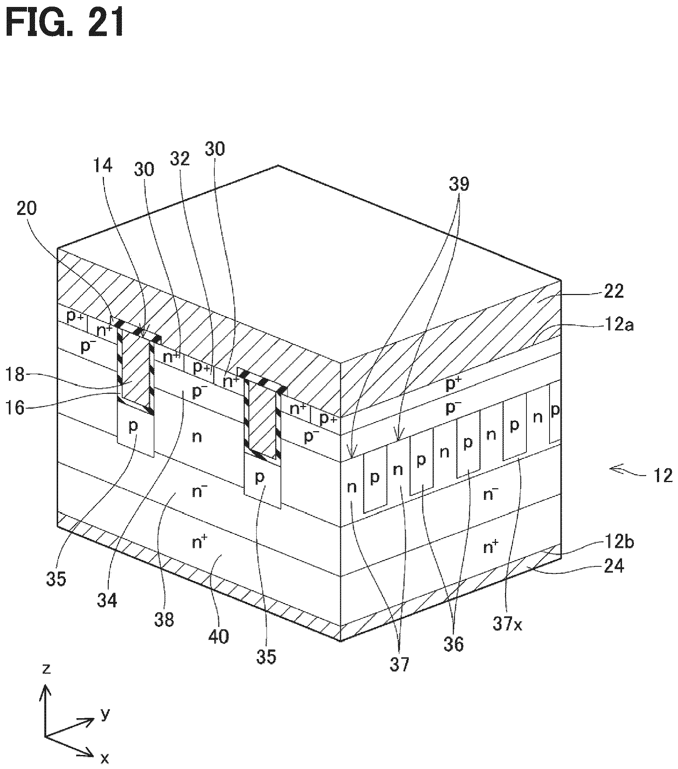

In a MOSFET of a fourth modification shown in FIG. 20, the bottom end of the p-type trench underlayer 35 is located at the same depth as the bottom end of the n-type deep layer 37. In a MOSFET of a fifth modification shown in FIG. 21, the bottom end of the p-type trench underlayer 35 is located lower than the bottom end of the n-type deep layer 37. In FIGS. 20 and 21, the p-type trench underlayer 35 is in contact with the drift layer 38. Even in these configurations, the p-type trench underlayer 35 provides the effects of reducing feedback capacitance and mitigating the electric field.

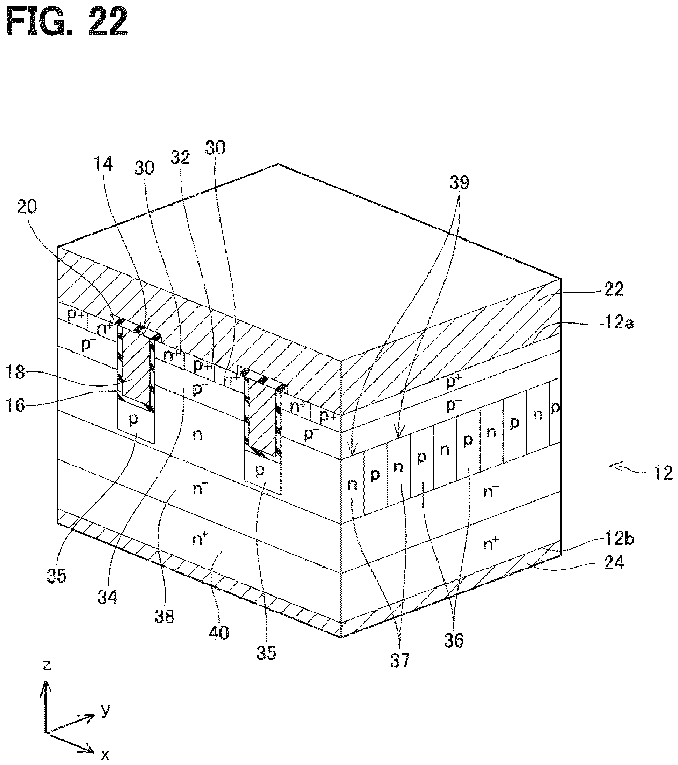

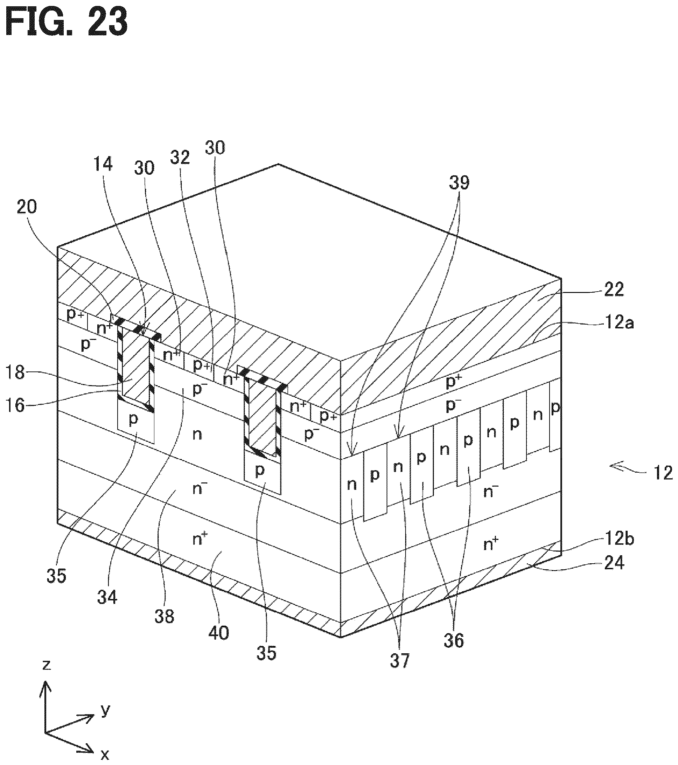

In a MOSFET of a sixth modification shown in FIG. 22, the bottom end of the p-type deep layer 36 is located at the same depth as the bottom end of the n-type deep layer 37. In a MOSFET of a seventh modification shown in FIG. 23, the bottom end of the p-type deep layer 36 is located lower than the bottom end of the n-type deep layer 37. In FIGS. 22 and 23, there is no n-type connection layer 37x below the p-type deep layer 36, and the p-type deep layer 36 is in contact with the drift layer 38. In these configurations, a high breakdown voltage can be obtained by the p-type deep layer 36.

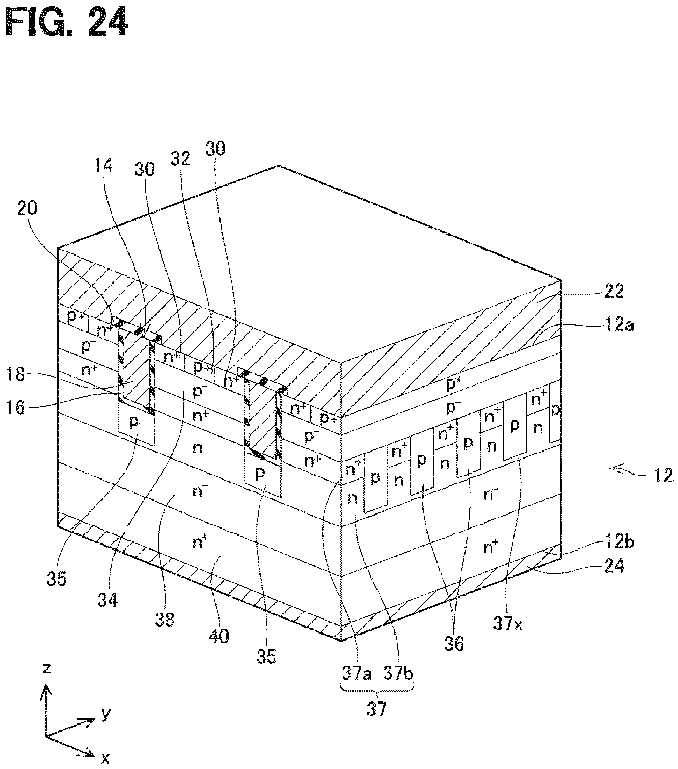

In a MOSFET of an eighth modification shown in FIG. 24, the n-type deep layer 37 has a first n-type deep layer 37a and a second n-type deep layer 37b. The first n-type deep layer 37a is disposed above the second n-type deep layer 37b. The first n-type deep layer 37a has a higher n-type impurity concentration than the second n-type deep layer 37b. The first n-type deep layer 37a is disposed above the lower end of the trench 14. By providing the first n-type deep layer 37a having a high n-type impurity concentration, a wider current path can be ensured in the n-type deep layer 37. Therefore, the on-resistance of the MOSFET can be further reduced.

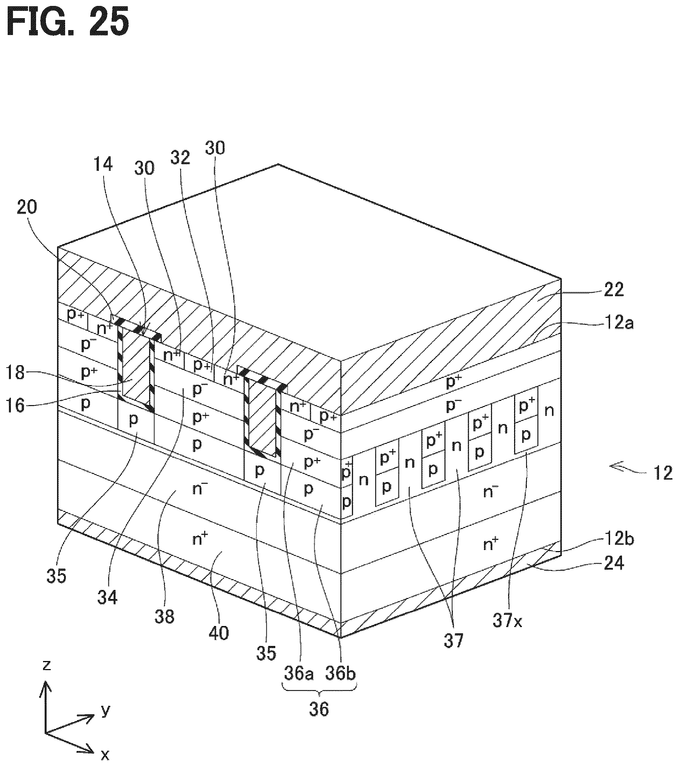

In a MOSFET of a ninth modification shown in FIG. 25, the p-type deep layer 36 has a first p-type deep layer 36a and a second p-type deep layer 36b. The first p-type deep layer 36a is disposed above the second p-type deep layer 36b. The first p-type deep layer 36a has a higher p-type impurity concentration than the second p-type deep layer 36b. The first p-type deep layer 36 a is disposed above the lower end of the trench 14. According to this configuration, the p-type impurity concentration in the p-type deep layer 36 can be partially increased while restricting the p-type impurity concentration at the intersection between the p-type deep layer 36 and the p-type trench underlayer 35 from becoming extremely high. Therefore, the occurrence of leakage current due to excessive ion implantation can be suppressed, and at the same time, a high breakdown voltage can be achieved by the p-type deep layer 36.

The configurations of the technology disclosed in this description are listed below.

### (Configuration 1)

A method for producing a field effect transistor includes:
a semiconductor substrate preparation step of preparing a semiconductor substrate having an n-type drift layer, a plurality of p-type deep layers, and a plurality of n-type deep layers, the plurality of p-type deep layers and the plurality of n-type deep layers being disposed on the n-type drift layer, the plurality of p-type deep layers extending along a first direction when the semiconductor substrate is viewed from above, the plurality of p-type deep layers being disposed at interval in a second direction perpendicular to the first direction, the plurality of n-type deep layers being disposed within the corresponding intervals, each of the plurality of n-type deep layers having an n-type impurity concentration higher than the n-type impurity concentration of the n-type drift layer;
a body layer formation step of forming a p-type body layer in contact with the plurality of p-type deep layers and the plurality of n-type deep layers from above by ion-implanting a p-type impurity into the semiconductor substrate;
a trench formation step of forming a trench in an upper surface of the semiconductor substrate, the trench being formed so that, when the semiconductor substrate is viewed from above, the trench intersects with the plurality of p-type deep layers, the trench penetrates the body layer, and a lower end of the trench is located above lower ends of the plurality of p-type deep layers;
a p-type trench underlayer formation step of forming a p-type trench underlayer connected to each of the p-type deep layers below the trench by implanting p-type impurity into a bottom surface of the trench while the upper surface of the semiconductor substrate is covered with an ion implantation mask; and
a gate electrode formation step of forming a gate insulating film and a gate electrode in the trench.

In the p-type trench underlayer formation step, a p-type impurity is implanted at a higher concentration than in the body layer formation step.

### (Configuration 2)

In the producing method according to Configuration 1, the ion implantation depth in the p-type trench underlayer formation step is shallower than the ion implantation depth in the body layer formation step.

### (Configuration 3)

In the producing method according to Configuration 1 or 2, in the p-type trench underlayer formation step, the p-type trench underlayer is formed so that a lower end of the p-type trench underlayer is located higher than a lower end of each of the n-type deep layers.

### (Configuration 4)

In the producing method according to any one of Configurations 1 to 3, in the p-type trench underlayer formation step, the p-type trench underlayer is formed to be in contact with the bottom surface of the trench. A total amount of p-type impurity in the p-type trench underlayer is set so that a non-depleted region remains in a part of the p-type trench underlayer in contact with the gate insulating film when a rated voltage is applied to the field effect transistor.

### (Configuration 5)

In the producing method according to any one of Configurations 1 to 4, in the p-type trench underlayer formation step, a p-type trench underlayer having a first p-type trench underlayer and a second p-type trench underlayer is formed. The second p-type trench underlayer has a higher p-type impurity concentration than the first p-type trench underlayer and is located above or below the first p-type trench underlayer.

### (Configuration 6)

In the producing method according to any one of Configurations 1 to 5, in the p-type trench underlayer formation step, a p-type impurity is implanted into the bottom surface of the trench in a state where the bottom surface and the side surface of the trench are exposed.

### (Configuration 7)

In the producing method according to any one of Configurations 1 to 6, in the trench formation step, an etching mask is formed on the upper surface of the semiconductor substrate, and the upper surface of the semiconductor substrate is etched through the etching mask to form the trench. In the p-type trench underlayer formation step, the etching mask is used as the ion implantation mask.

### (Configuration 8)

In the producing method according to any one of Configurations 1 to 7, in the semiconductor substrate preparation step, the semiconductor substrate having an n-type connection layer is prepared. The n-type connection layer is disposed under each of the p-type deep layers to connect the n-type deep layers to each other. An n-type impurity concentration of the n-type connection layer is higher than an n-type impurity concentration of the n-type drift layer.

Although the embodiments have been described in detail above, these are merely examples and do not limit the scope of claims. The techniques described in claims include various modifications of the specific examples illustrated above. The technical elements described in the present specification or the drawings exhibit technical usefulness alone or in various combinations, and are not limited to the combinations described in the claims at the time of filing. In addition, the techniques illustrated in the present specification or drawings achieve a plurality of objectives at the same time, and achieving one of the objectives itself has technical usefulness.

## Claims

1. A method for producing a field effect transistor comprising:
preparing, in a semiconductor substrate preparation step, a semiconductor substrate having an n-type drift layer (38), a plurality of p-type deep layers (36), and a plurality of n-type deep layers (37), the plurality of p-type deep layers and the plurality of n-type deep layers being arranged above the n-type drift layer, the p-type deep layers extending along a first direction and being arranged with a gap in a second direction perpendicular to the first direction when the semiconductor substrate is viewed from an upper side, the n-type deep layer being arranged within the gap, an n-type impurity concentration of the n-type deep layer being higher than an n-type impurity concentration of the n-type drift layer;
forming, in a body layer formation step, a p-type body layer (34) in contact with the plurality of p-type deep layers and the plurality of n-type deep layers from an upper side by ion-implanting a p-type impurity into the semiconductor substrate;
forming, in a trench formation step, a trench (14) on an upper surface of the semiconductor substrate such that the trench intersects with the plurality of p-type deep layers when the semiconductor substrate is viewed from an upper side, that the trench penetrates the body layer, and that a lower end of the trench is located above lower ends of the plurality of p-type deep layers;
forming, in a p-type trench underlayer formation step, a p-type trench underlayer (35) connected to each of the p-type deep layers at a lower side of the trench by implanting a p-type impurity into a bottom surface of the trench in a state where the upper surface of the semiconductor substrate is covered with an ion implantation mask; and
forming, in a gate electrode formation step, a gate insulating film (16) and a gate electrode (18) in the trench, wherein
a p-type impurity is implanted at a higher concentration in the p-type trench underlayer formation than in the body layer formation step.

2. The method according to claim 1, wherein an ion implantation depth in the p-type trench underlayer formation step is shallower than an ion implantation depth in the body layer formation step.

3. The method according to claim 1 or 2, wherein in the p-type trench underlayer formation step, the p-type trench underlayer is formed such that a lower end of the p-type trench underlayer is located higher than a lower end of each of the n-type deep layers.

4. The method according to claim 1 or 2, wherein
the p-type trench underlayer is formed in contact with the bottom surface of the trench in the p-type trench underlayer formation step, and
a total amount of the p-type impurity in the p-type trench underlayer is set such that a non-depleted region (60) remains in a part of the p-type trench underlayer in contact with the gate insulating film when a rated voltage is applied to the field effect transistor.

5. The method according to claim 1 or 2, wherein
in the p-type trench underlayer formation step,
the p-type trench underlayer having a first p-type trench underlayer (35a) and a second p-type trench underlayer (35b) is formed, and
the second p-type trench underlayer has a higher p-type impurity concentration than the first p-type trench underlayer and is located above or below the first p-type trench underlayer.

6. The method according to claim 1 or 2, wherein in the p-type trench underlayer formation step, a p-type impurity is implanted into the bottom surface of the trench in a state where the bottom surface and a side surface of the trench are exposed.

7. The method according to claim 1 or 2, wherein
in the trench formation step, an etching mask is formed on the upper surface of the semiconductor substrate, and the upper surface of the semiconductor substrate is etched through the etching mask to form the trench, and
in the p-type trench underlayer formation step, the etching mask is used as the ion implantation mask.

8. The method according to claim 1 or 2, wherein
in the semiconductor substrate preparation step, the semiconductor substrate having an n-type connection layer (37x) is prepared,
the n-type connection layer is disposed under each of the p-type deep layers and connects the n-type deep layers to each other, and
an n-type impurity concentration of the n-type connection layer is higher than an n-type impurity concentration of the n-type drift layer.
